# EUROPÄISCHE PATENTSCHRIFT

(11) **EP 2 291 867 B1**
(45) Veröffentlichungstag und Bekanntmachung des Hinweises auf die Patenterteilung: **16.05.2012**
(21) Anmeldenummer: 10719944.0
(22) Anmeldetag: 17.05.2010
(51) Int. Cl.: H01L 31/18

(54) **VERFAHREN ZUM VEREINZELN VON SILIZIUM-SOLARZELLEN**
METHOD FOR SEPARATING SILICON SOLAR CELLS
PROCEDE DE SEPARATION DE CELLULES SOLAIRES AU SILICIUM

(30) Priorität: 20.05.2009 DE 102009026410
(43) Veröffentlichungstag der Anmeldung: 09.03.2011
(73) Patentinhaber: Rofin-Baasel Lasertech GmbH & Co. KG, 82319 Starnberg (DE)
(72) Erfinder: MAYERHOFER, Roland, 91341 Röttenbach (DE)
(74) Vertreter: Mörtel & Höfner
(86) Internationale Anmeldenummer: PCT/EP2010/056708
(87) Internationale Veröffentlichungsnummer: WO 2010/133536

(56) Entgegenhaltungen:
- DE-A1- 19 624 677
- US-A- 6 159 757
- ROLAND MAYERHOFER ET AL: "Laser Micro-Processing in Solar Cell Production" PHOTOVOLTAIC ENERGY CONVERSION, CONFERENCE RECORD OF THE 2006 IEEE 4TH WORLD CONFERENCE ON, IEEE, PI, 1. Mai 2006 (2006-05-01), Seiten 1115-1118, XP031007505 ISBN: 978-1-4244-0016-4

## Beschreibung

Die Erfindung bezieht sich auf ein Verfahren zum Vereinzeln von Silizium-Solarzellen.

Bei der Herstellung von Silizium-Solarzellen werden in einem Siliziumwafer in der Regel eine große Anzahl einzelner Silizium-Solarzellen hergestellt, die in einem abschließenden Fertigungsschritt vereinzelt, d.h. voneinander getrennt werden müssen. Im Stand der Technik erfolgt dies entweder mit einem mechanischen Sägeverfahren oder mit einem beispielsweise aus der WO 2008/084206 A1 bekannten Laserschneidverfahren. Das Dokument R. Mayerhafer et al., Photvoltaic Energy Conversion, Conference Record of the 2006 IEEE 4th World Conference on, IEEE, PI Mai 2006, Seiten 1115-1118 beschreibt ein Verfahren zum Vereinzeln von Solarzellen. Werden diese Verfahren einstufig durchgeführt, d.h. erfolgt eine Trennung in einem einzigen Prozessschritt, so kann es vorkommen, dass die einzelnen Silizium-Solarzellen insbesondere beim Laserschneiden kurzgeschlossen werden. Ursache hierfür ist, dass in der Schneidfuge eine Schmelzzone entsteht, die mit Dotierungselementen angereichert sein kann. Dadurch kann am Rand der Schneidfuge eine Zone entstehen, in der die Dotierungselemente vermischt sind und der pn-Übergang zerstört ist. Dies kann zu einem Kurzschluss zwischen der Vorderseite, d.h. der Flachseite der Solarzelle, in deren Nähe sich der pn-Übergang befindet, und der Rückseite führen. Dieses Problem tritt sowohl beim konventionellen Laserschneiden, bei dem mit einem in die Schneidfuge mit hoher Geschwindigkeit einströmenden Schneidgas die Schmelze ausgetrieben wird, als auch beim einstufigen Laserschneiden mit einem Laserablationsverfahren auf, bei dem das Material in erster Linie durch Verdampfen aus der Schneidfuge entweicht, und bei dem in der Regel ein güte-geschalteter Festkörperlaser eingesetzt wird. Auch beim mechanischen Trennen durch Sägen ist ein solcher Kurzschluss nicht ausgeschlossen, da der metallische Kontakt an der Rückseite der Silizium-Solarzelle ebenfalls an den Schnittflächen verschmiert wird.

Um dieses Problem zu vermeiden, ist es bekannt, beim Vereinzeln von Silizium-Solarzellen einen zweistufigen Prozess einzusetzen, bei dem im ersten Schritt mit einem Laserstrahl eine Nut in den Siliziumwafer eingebracht und anschließend der Siliziumwafer entlang dieser Nuten mechanisch aufgebrochen wird.

Das anschließende Brechen des Siliziumwafers erfordert aber einen zusätzlichen Prozessschritt mit einer anderen Fertigungstechnik. Außerdem können beim Aufbrechen einzelne Silizium-Solarzellen zerstört werden.

Der Erfindung liegt daher die Aufgabe zu Grunde, ein Verfahren zum Vereinzeln von Silizium-Solarzellen anzugeben, mit dem die vorstehend genannten Nachteile vermieden sind.

Die genannte Aufgabe wird gemäß der Erfindung gelöst mit einem Verfahren mit den Merkmalen des Patentanspruches 1. Bei diesem Verfahren wird in einem ersten Arbeitsschritt in einen die Silizium-Solarzellen enthaltenden Siliziumwafer mit einem ersten Laserstrahl entlang einer Trennlinie in eine einem pn-Übergang im Siliziumwafer benachbarte Vorderseite des Siliziumwafers eine Nut eingebracht, die eine zumindest bis zum pn-Übergang reichende Tiefe aufweist und sich bis zu einem seitlichen Rand des Siliziumwafers erstreckt. In einem zweiten Arbeitsschritt wird der Siliziumwafer mit einem auf die Nut gerichtete zweiten Laserstrahl entlang der Trennlinie geschnitten, wobei das während des Schneidens entstehende Schmelzgut mit einem zumindest annähernd in Richtung des zweiten Laserstrahls strömenden Schneidgas aus der beim Schneiden entstehenden Schneidfuge ausgetrieben wird.

Da sich die Nut zumindest bis in eine Tiefe des Siliziumwafers erstreckt, in der sich der pn-Übergang befindet, entsteht beim Laserschneiden in der Schmelzzone allenfalls ein p-Dotierstoff enthaltendes Schmelzgut. Da dieses in Richtung zur Rückseite des Siliziumwafers ausgetrieben wird, kann sich dieses nicht an der n-dotierten Seitenwand der Nut anlagern. Dadurch kann ein am Rand entstehender Kurzschluss der Silizium-Solarzelle vermieden werden.

Besonders gute Ergebnisse werden erzielt, wenn sowohl erster als auch zweiter Laserstrahl gepulst sind, wobei die Pulsdauer des ersten Laserstrahls kürzer ist als die Pulsdauer des zweiten Laserstrahls. Erster und zweiter Laserstrahl können dabei sowohl von zwei unterschiedlichen Lasern als auch von einem Laser erzeugt werden, der in entsprechend unterschiedlichen Betriebsarten arbeiten kann.

Zur weiteren Erläuterung der Erfindung wird auf das Ausführungsbeispiel der Zeichnung verwiesen. Es zeigen:
Fig.1 einen eine Mehrzahl von Silizium-Solarzellen enthaltenden Siliziumwafer in einer schematischen Draufsicht auf eine seiner Flachseiten,
Fig. 2, 4 und 6 jeweils einen Silizium-Solarzellen enthaltenden Siliziumwafer an einem seiner Ränder in einem Längsschnitt entlang einer Trennlinie während der Durchführung des ersten Arbeitsschrittes, am Beginn des zweiten Arbeitsschrittes bzw. während dem Durchführen des zweiten Arbeitsschrittes,
Fig. 3, 5 und 7 den zu den Fig. 1, 3 und 5 jeweils korrespondierenden Arbeitsschritt in einer Draufsicht in Richtung der Trennlinie auf eine Schmalseite des Siliziumwafers.

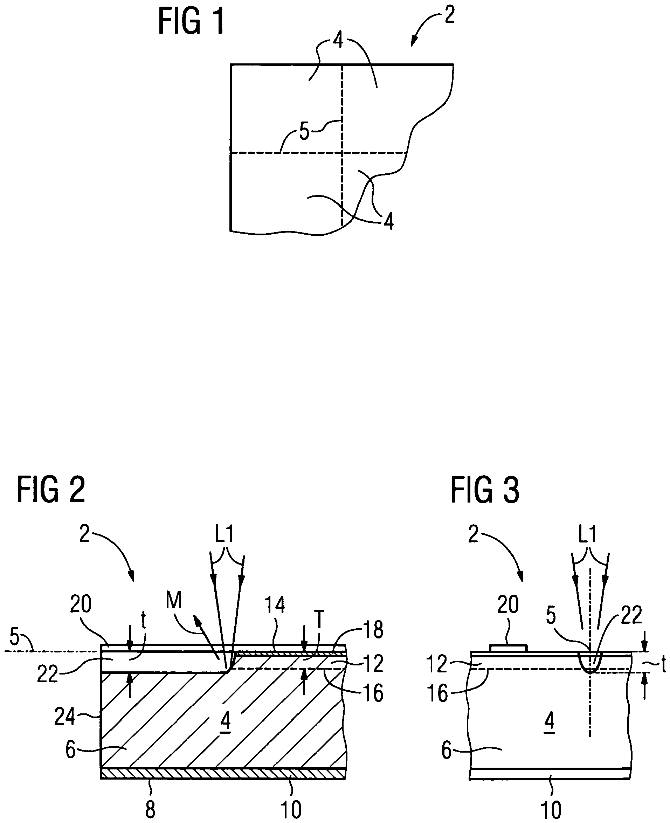

Gemäß Fig. 1 sind in einem Siliziumwafer 2 eine Mehrzahl fertig prozessierter Silizium-Solarzellen 4 angeordnet, die in einem anschließenden, nachfolgend erläuterten Fertigungsschritt an vorgegebenen Trennlinien 5 voneinander getrennt, d.h. vereinzelt werden.

Gemäß Fig. 2 und 3 ist der Siliziumwafer 2 aus einem als Basis dienenden p-dotierten Siliziumsubstrat 6 aufgebaut, das auf einer Rückseite 8 mit einem metallischem Basiskontakt 10 versehen ist. In dem p-dotierten Siliziumsubstrat 6 ist durch Zugabe eines n-Dotierstoffes auf der der Rückseite 8 gegenüberliegenden Vorderseite 14 eine n-dotierte Emitterschicht 12 hergestellt worden, die nur wenige µm dick ist, so dass sich in einer nur wenige µm betragenden Tiefe T ein gestrichelt eingezeichneter pn-Übergang 16 befindet. Die Vorderseite 14 des Siliziumwafers 2 ist außerdem mit einer Antireflexionsschicht 18 sowie mit einer Mehrzahl von Emitterkontakten 20 versehen.

Zum Vereinzeln der Silizium-Solarzellen 4 wird in einem ersten Arbeitsschritt mit einem ersten Laserstrahl L1 entlang einer der Trennlinien 5 durch ein Laserabtrags- bzw. Laserablationsverfahren in die dem pn-Übergang 16 benachbarte Vorderseite 14 des Siliziumwafers 2 eine Nut 22 eingebracht (eingeritzt), deren Tiefe t sich zumindest bis zur Tiefe T des pn-Überganges 16, die typisch etwa 1 µm beträgt erstreckt. Im Beispiel der Fig. 2 und 3 beginnt der Abtrag an einem seitlichen Rand 24 des Siliziumwafers 2. Der Abtrag kann aber grundsätzlich auch an einer vom Rand des Siliziumwafers 2 beabstandeten Stelle beginnen. Wesentlich ist aber, dass sich die fertiggestellte Nut 22 bis zu den seitlichen Rändern 24 des Siliziumwafers 2 erstreckt. Der erste Laserstrahl L1 ist gepulst, wobei die Pulsdauern vorzugsweise im Nanosekundenbereich liegen und Wellenlängen im Bereich zwischen 200nm - 2000nm verwendet werden. Grundsätzlich sind auch kürzere Pulsdauern geeignet, die unterhalb des Nanosekundenbereichs liegen. Die Tiefe t der Nut 22 überschreitet dabei die Tiefe t des pn-Überganges vorzugsweise um mehrere Mikrometer, beispielsweise um mehr als 10µm. In der Praxis hat sich eine Tiefe der Nut 22 von etwa 12-15µm als geeignet herausgestellt

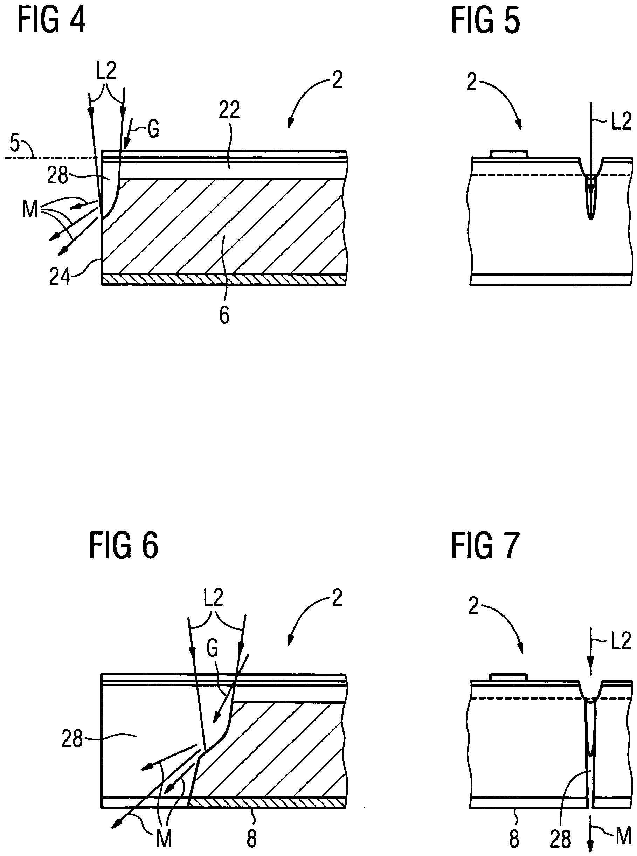

Nach Fertigstellen der Nut 22 wird gemäß Fig. 4 und 5 das Substrat 2 in einem zweiten Arbeitsschritt mit einem in die Nut 22 gerichteten zweiten, vorzugsweise ebenfalls gepulsten Laserstrahl L2 beginnend am seitlichen Rand 24 entlang der Trennlinie 5 geschnitten. Dabei wird das während des Laserschneidens entstehende Schmelzgut M mit einem annähernd in Richtung des zweiten Laserstrahls L2 mit hoher Geschwindigkeit strömenden Schneidgas G aus einer am Beginn des Laserschneidens entstehenden und noch nicht bis zur Rückseite 8 reichenden Schneidfuge 28 seitlich am Rand 24, d.h. mit einer in Richtung des zweiten Laserstrahls L2 orientierten, zur Rückseite hin gerichteten Strömungskomponente ausgetrieben. Auf diese Weise wird verhindert, dass sich beim Aufschmelzen der Basis, d.h. des p-dotierten Bereiches des Siliziumsubstrates 6 eine mit p-Dotierstoff angereicherte Schmelzzone ausbildet, die sich bis zur n-dotierten Seitenwand der Nut 22 ausbreitet und diese benetzt. Mit anderen Worten: Das mit p-Dotierstoffen angereicherte Schmelzgut M kommt nicht in Kontakt mit der n-dotierten Emitterschicht 12. Die Pulsdauern des zweiten Laserstrahls L2 liegen typisch im Mikrosekundenbereich, wobei die Wellenlänge des zweiten Laserstrahls L2 vorzugsweise im nahen Infrarotbereich liegt.

Gemäß Fig. 6 und 7 erreicht die Schneidfuge 28 die Rückseite 8, so dass ein zur Rückseite 8 hin offener und sich durch Vorschub des Laserstahls L2 in Richtung der Trennlinie 5 ausbreitender Trennspalt entsteht, aus dem das Schmelzgut M zur Rückseite 8 hin ausgetrieben werden kann. Auf diese Weise bleibt der pn-Übergang an den Seitenwänden des Trennspaltes erhalten.

## Patentansprüche

1. Verfahren zum Vereinzeln von Silizium-Solarzellen (4), bei dem in einem ersten Arbeitsschritt in einen die Silizium-Solarzellen (4) enthaltenden Siliziumwafer (2) mit einem ersten Laserstrahl (L1) entlang einer Trennlinie (5) in eine einem pn-Übergang (16) im Siliziumwafer (2) benachbarte Vorderseite (14) des Siliziumwafers (2) eine Nut (22) eingebracht wird, die eine zumindest bis zum pn-Übergang (16) reichende Tiefe (t) aufweist und sich bis zu einem seitlichen Rand (24) des Siliziumwafers (2) erstreckt, und bei dem in einem zweiten Arbeitsschritt der Siliziumwafer (2) mit einem in die Nut (22) gerichteten zweiten Laserstrahl (L2) beginnend am seitlichen Rand (24) entlang der Trennlinie (5) geschnitten wird, wobei das während des Schneidens entstehende Schmelzgut (M) mit einem zumindest annähernd in Richtung des zweiten Laserstrahls (L2) strömenden Schneidgas (G) aus der beim Schneiden entstehenden Schneidfuge (28) ausgetrieben wird.

2. Verfahren nach Anspruch 1, bei dem erster und zweiter Laserstrahl gepulst sind, wobei die Pulsdauer des ersten Laserstrahls kürzer ist als die Pulsdauer des zweiten Laserstrahls (L2).

## Claims

1. Method for separating silicon solar cells (4), in which, in a first processing step, a groove (22) is formed in a silicon wafer (2) containing the silicon solar cells (4) by means of a first laser beam (L1) along a separating line (5) in a front face (14) of the silicon wafer (2) adjacent to a pn junction (16) in the silicon wafer (2), said groove having a depth (t) reaching at least as far as the pn junction (16) and extending as far as a lateral edge (24) of the silicon wafer (2), and in which, in a second processing step, the silicon wafer (2) is cut along the separating line (5) starting at the lateral edge (24) by means of a second laser beam (L2) directed into the groove (22), wherein the molten material (M) produced during the cutting operation is driven out of the cutting kerf (28) during the cutting operation by means of a cutting gas (G) flowing at least approximately in the direction of the second laser beam (L2).

2. Method according to claim 1, in which first and second laser beams are pulsed, wherein the pulse duration of the first laser beam is shorter than the pulse duration of the second laser beam (L2).

## Revendications

1. Procédé d'individualisation de photopiles (4) au silicium, dans lequel, dans un premier stade opératoire, on ménage dans une tranche (2) de silicium contenant les photopiles (4) au silicium, par un premier faisceau (L1) laser, le long d'une ligne (5) de séparation dans une face (14) avant voisine d'une jonction pn (16) dans la tranche (2) de silicium une rainure (22), qui a une profondeur (t) allant au moins jusqu'à la jonction pn (16) et qui s'étend vers un bord (24) latéral de la tranche (2) de silicium, dans lequel, dans un deuxième stade opératoire, on coupe la tranche (2) de silicium le long de la ligne (5) de séparation en commençant au bord (24) latéral par un deuxième faisceau (L2) laser dirigé dans la rainure (22), le produit (M) fondu se créant pendant la coupe étant expulsé de l'entaille (28) de coupe se créant lors de la coupe par un gaz (G) de coupe s'écoulant au moins à peu près dans la direction du deuxième faisceau (L2) laser.

2. Procédé suivant la revendication 1, dans lequel le premier et le deuxième faisceaux laser sont pulsés, la durée d'impulsion du premier faisceau laser étant plus courte que la durée d'impulsion du deuxième faisceau (L2) laser.
